# EUROPÄISCHE PATENTSCHRIFT

(11) **EP 1 227 006 B1**
(45) Veröffentlichungstag und Bekanntmachung des Hinweises auf die Patenterteilung: **18.08.2004**
(21) Anmeldenummer: 02000647.4
(22) Anmeldetag: 11.01.2002
(51) Int. Cl.: B60R 16/02

(54) **Druckausgleichseinrichtung für ein Gehäuse eines Steuergerätes**
Pressure equalizing device for a housing of a control apparatus
Installation d'équilibrage de pression pour un boîtier d'un appareil de commande

(30) Priorität: 26.01.2001 DE 10103594
(43) Veröffentlichungstag der Anmeldung: 31.07.2002
(73) Patentinhaber: AUDI AG, 85045 Ingolstadt (DE)
(72) Erfinder: Stock, Bernhard, 85111 Adelschlag (DE); Aigner, Konrad, 85290 Geisenfeld (DE); Kreipp, Alfons, 91171 Greding (DE)
(74) Vertreter: Thielmann, Frank

(56) Entgegenhaltungen:
- EP-A- 0 113 073
- EP-A- 0 484 288
- WO-A-01/69993
- DE-A- 4 329 980
- DE-U- 29 901 601

## Beschreibung

Steuergeräte, insbesondere eines Kraftfahrzeuges weisen ein mit einer Druckausgleichseinrichtung ausgestattetes Gehäuse auf, so dass sich der Luftdruck im Inneren des Gehäuses und der atmosphärische Aussendruck ausgleichen können. Es ist bekannt hierzu am Gehäuse Ventile vorzusehen, die für einen entsprechenden Druckausgleich sorgen. Solche Ventile sind sehr aufwendig, da sie zum einen für einen Druckausgleich sorgen müssen und zum anderen verhindern müssen, dass von aussen Feuchtigkeit in das Gehäuse gelangen kann.

Aus der gattungsbildenden DE 299 01 601 U1 ist eine Druckausgleichsvorrichtung für einen elektrischen Schaltschrank bekannt, die aus einem Luftleitkanal besteht, der aus dem Schaltschrank heraus in eine Gasbehandlungskammer führt.

Aufgabe der Erfindung ist es daher eine Druckausgleichseinrichtung der Eingangs genannten Art derart auszugestalten, dass bei einfachem kostengünstigen Aufbau ein Druckausgleich möglich ist und keine Feuchtigkeit in das Gehäuse gelangen kann.

Die Aufgabe wird erfindungsgemäß durch den Gegenstand des Patentanspruchs 1 gelöst.

Vorteil der Erfindung ist, dass der Druckausgleich über in die oder an einen der elektrischen Anschlussleitung integrierten Luftleitkanal erfolgt. Es kann somit auf ein gesondertes Druckausgleichselement am Gehäuse verzichtet werden, wodurch sich ein kostengünstigerer Aufbau ergibt, durch den ein Druckausgleich möglich ist ohne dass Wasser in das Gehäuse gelangen kann.

Weitere Vorteile und Einzelheiten der Erfindung ergeben sich aus der nachfolgenden Beschreibung eines Ausführungsbeispiels anhand der Zeichnungen.

Es zeigt:
- Figur 1: eine Druckausgleichseinrichtung nach der Erfindung in einer ersten und
- Figur 2: in einer zweiten Ansicht und
- Figur 3: einen Querschnitt durch ein erstes,
- Figur 4: einen Querschnitt durch ein zweites und
- Figur 5: einen Querschnitt durch ein drittes Ausführungsbeispiel einer elektrischen Anschlussleitung nach den Figuren 1 und 2.

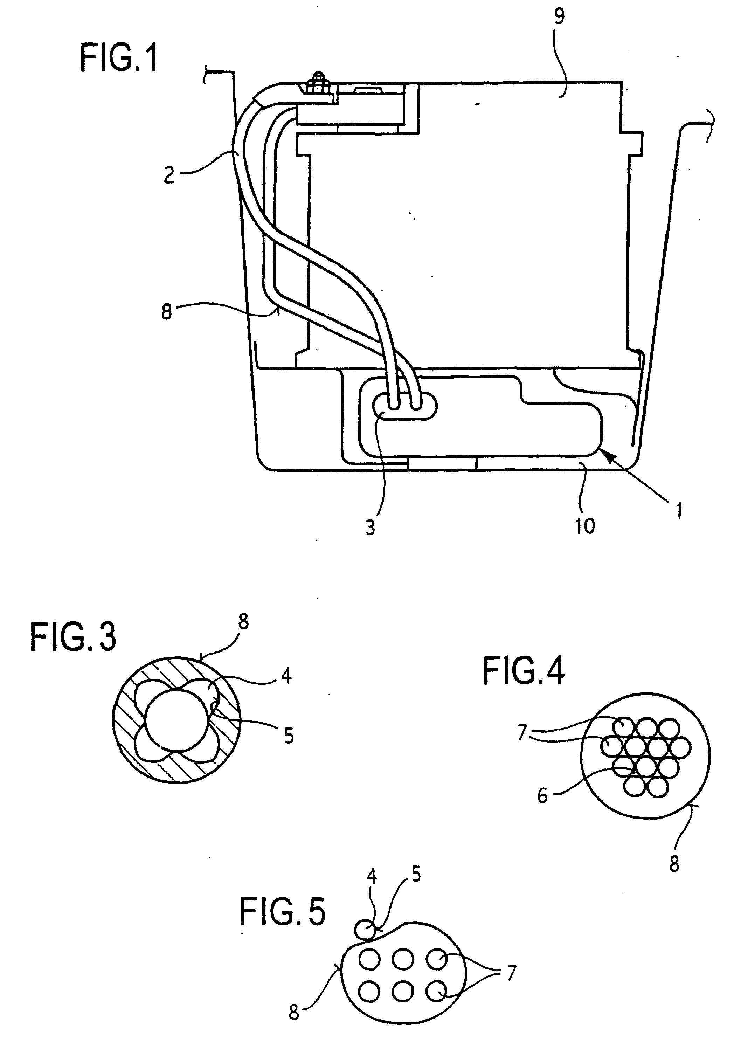

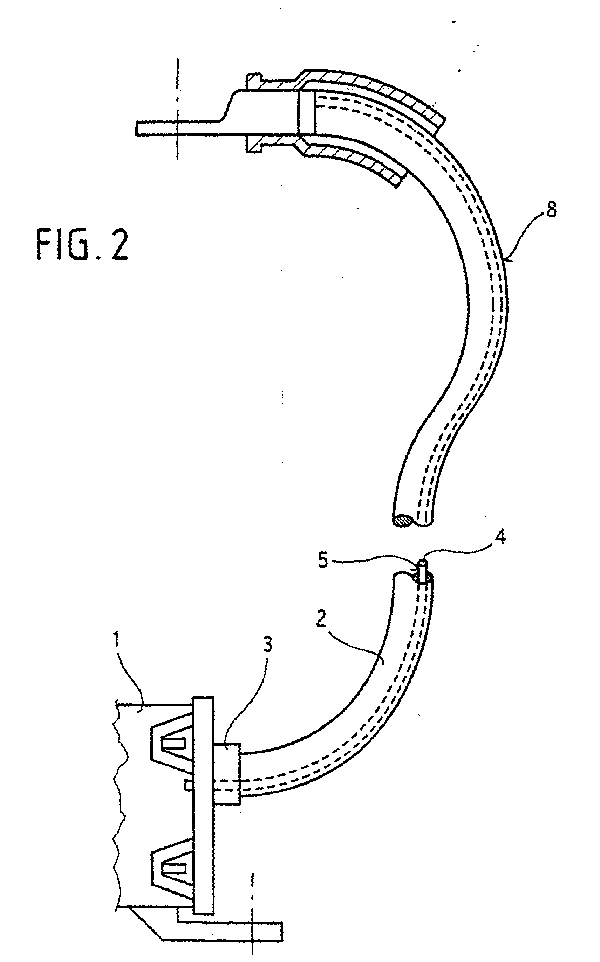

In den Figuren ist ein Gehäuse eines Steuergerätes mit dem Bezugszeichen 1 gekennzeichnet. Im Inneren des Gehäuses 1 ist eine nicht näher dargestellte Elektronik angeordnet, die zur Steuerung und/oder Regelung von Funktionen eines Kraftfahrzeuges dienen kann. Zur elektrischen Spannungsversorgung und ggf. zur Herausgabe von Steuer- und/oder Regelsignalen ist zumindest eine elektrische Anschlussleitung 2 vorgesehen, die über ein Dichtelement 3 in das Gehäuse 1 führt. Gemäß einer Variante der Erfindung ist die elektrische Anschlussleitung 2 mit einem Luftleitkanal 4 ausgebildet, der zum Druckausgleich zwischen dem Luftinnendruck im Gehäuse 1 und dem atmosphärischen Luftaussendruck sorgt. Der Luftleitkanal 4 kann als ein der elektrischen Anschlussleitung 2 zugeordneter Schlauch 5 (Figuren 3, 5) oder auch von zumindest einem Hohlraum 6 gebildet werden, der sich durch die Zuordnung der elektrischen Leitungen 7 ergibt. Aus der Figur 3 geht hervor, dass sowohl der Luftleitkanal 4 (Schlauch 5) als auch die elektrischen Leitungen 7 von einer gemeinsamen Hülle 8 umgeben sind, wodurch sich ein besonders kompakter Aufbau ergibt. Im Rahmen der Erfindung (Figur 5) ist es aber auch möglich einen separaten Luftleitkanal 4, beispielsweise als Schlauch 5 ausgebildet, dem Gehäuse 1 zuzuordnen, der mit der elektrischen Anschlussleitung 2 geführt ist.

Aus der Figur 1 ergibt sich, dass das Gehäuse 1 des Steuergerätes unterhalb der Batterie 9 eines Kraftfahrzeuges in einem dort ausgebildeten Raum 10 angeordnet ist. Hier kommt der Gegenstand der vorliegenden Erfindung besonders gut zum Tragen, da es nicht auszuschließen ist, dass Wasser in diesen Raum 10 gelangt und nicht oder nicht ausreichend abgeführt werden kann. Ohne die erfindungsgemäße Ausgestaltung könnte in Abhängigkeit von den Druckverhältnissen insbesondere Wasser in das Gehäuse 1 gelangen und die Elektronik zerstören.

### Bezugszeichenliste

- 1: Gehäuse
- 2: Elektrische Anschlussleitung
- 3: Dichtelement
- 4: Luftleitkanal
- 5: Schlauch
- 6: Hohlraum
- 7: Elektrische Leitungen
- 8: Gemeinsame Hülle
- 9: Batterie
- 10: Raum

## Patentansprüche

1. Druckausgleichseinrichtung für ein Gehäuse (1) eines Steuergerätes insbesondere eines Kraftfahrzeuges,
mit einer dem Steuergerät zugeordneten elektrischen Anschlussleitung (2) und
einem Luftleitkanal (4) für den Druckausgleich,
**dadurch gekennzeichnet, dass**
der Luftleitkanal (4) in die oder an der elektrischen Anschlussleitung (2) integriert ist.

2. Druckausgleichseinrichtung nach Anspruch 1,
wobei der Luftleitkanal (4) als Schlauch (5) ausgebildet ist.

3. Druckausgleichseinrichtung nach Anspruch 1,
wobei der Luftleitkanal (4) von einem durch elektrische Leitungen (7) der Anschlußleitung (2) gebildeten Hohlraum (6) gebildet ist.

## Claims

1. Pressure-equalizing device for a housing (1) of control apparatus particularly of a vehicle,
with an electrical connection cable (2) that is associated with the control apparatus and
an air conduit (4) for the pressure-equalization,
**characterized in that**
the air conduit (4) is built into the electrical connection cable (2).

2. Pressure-equalizing device in accordance with claim 1,
in which the air conduit (4) is a tube (5).

3. Pressure-equalization device in accordance with claim 1,
in which the air conduit (4) is formed by a cavity itself formed by electrical conductors (7) of the connection cable (2).

## Revendications

1. Dispositif d'équilibrage de la pression pour un boîtier (1) d'un appareil de commande, en particulier d'un véhicule automobile,
avec une ligne de raccordement électrique (2), associée à l'appareil de commande, et
un canal de guidage d'air (4), pour l'équilibrage de pression,
**caractérisé en ce que**
le canal de guidage d'air (4) et intégré dans ou à la ligne de raccordement électrique (2).

2. Dispositif d'équilibrage de la pression selon la revendication 1, le canal de guidage d'air (4) étant réalisé sous la forme de tuyau (5).

3. Dispositif d'équilibrage de la pression selon la revendication 1, le canal de guidage d'air (4) étant formé par un espace creux (6), formé par des lignes électriques (7) appartenant à la ligne de raccordement (2).
